(19) Europäisches Patentamt / European Patent Office / Office européen des brevets

(11) **EP 2 856 187 B1**

(12) **FASCICULE DE BREVET EUROPEEN**

(45) Date de publication et mention de la délivrance du brevet:
**06.04.2016 Bulletin 2016/14**

(21) Numéro de dépôt: **13724850.6**

(22) Date de dépôt: **24.05.2013**

(51) Int Cl.:
**G01R 31/36** $^{(2006.01)}$

(86) Numéro de dépôt international:
**PCT/EP2013/060796**

(87) Numéro de publication internationale:
**WO 2013/175005 (28.11.2013 Gazette 2013/48)**

(54) **DISPOSITIF ET PROCEDE DE DETERMINATION D'UN ETAT D'ENERGIE A PARTIR DES DONNEES ISSUES DU PROCEDE DE TRAITEMENT**

VORRICHTUNG UND VERFAHREN ZUR BESTIMMUNG EINES ENERGIEZUSTANDES GEMÄSS DATEN AUS DEM VERARBEITUNGSVERFAHREN

DEVICE AND METHOD FOR DETERMINING A POWER STATUS ACCORDING TO DATA FROM THE PROCESSING METHOD

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**

(30) Priorité: **24.05.2012 FR 1254793**

(43) Date de publication de la demande:
**08.04.2015 Bulletin 2015/15**

(73) Titulaire: **Commissariat à l'Énergie Atomique et aux Énergies Alternatives**
**75015 Paris (FR)**

(72) Inventeurs:
• **FERNANDEZ, Eric**
 **F-38760 Saint Paul de Varces (FR)**
• **DELAPLAGNE, Tony**
 **73490 La Ravoire (FR)**
• **FRANCHI, Romain**
 **38000 Grenoble (FR)**
• **MAMADOU, Kelli**
 **F-97200 Fort de France (FR)**

(74) Mandataire: **Novaimo**
 **Bâtiment Europa 2**
 **310 avenue Marie Curie**
 **Archamps Technopole**
 **74166 Saint-Julien-en-Genevois Cedex (FR)**

(56) Documents cités:
| | |
|---|---|
| EP-A2- 2 426 503 | WO-A1-2006/058970 |
| WO-A1-2011/000872 | DE-A1- 3 736 481 |
| DE-A1-102005 062 148 | DE-A1-102009 036 083 |
| US-A- 6 057 688 | US-A1- 2011 112 781 |

• **DURR M ET AL: "Dynamic model of a lead acid battery for use in a domestic fuel cell system", JOURNAL OF POWER SOURCES, ELSEVIER SA, CH, vol. 161, no. 2, 27 octobre 2006 (2006-10-27), pages 1400-1411, XP027938702, ISSN: 0378-7753 [extrait le 2006-10-27]**

**Description**

**Domaine technique de l'invention**

L'invention concerne le domaine des accumulateurs électrochimique.

L'invention a pour objet plus particulièrement l'utilisation de données complétées de points de fonctionnement en énergie de l'accumulateur.

Pour cela l'invention est notamment relative à un procédé de traitement d'un premier ensemble de quadruplets de valeurs relatifs à des points de fonctionnement d'un accumulateur électrochimique incluant puissance, température, état d'énergie et énergie restante, ou puissance, température, état d'énergie et pente.

**État de la technique**

Traditionnellement, l'indicateur d'état de l'accumulateur est basé sur une évaluation de la quantité de charges électriques stockées dans l'accumulateur. La mesure de l'intensité du courant extrait, et/ou fourni à l'accumulateur, associée à un calcul intégral, permet la réalisation de l'indicateur "d'état de charge" SOC (pour « State Of Charge » en anglais).

Autrement dit, on applique les formulations suivantes :

$$Q = \int i.dt + Q0$$

$$SOC = 100.Q/Q\max$$

où Q représente la quantité de charges stockées dans la batterie à l'instant t en Coulomb,
Q0 représente la quantité de charges initiales stockées dans la batterie en Coulomb,
Qmax représente la quantité de charges maximum de la batterie (batterie pleine) en Coulomb, et
SOC représente un état de charge en pourcentage.

Cet indicateur usuel d'état de charge n'est pas satisfaisant dans la mesure où il ne permet pas de prendre en compte des pertes de l'accumulateur, notamment les pertes dues à sa résistante interne.

En effet, plus la résistance interne d'un accumulateur sera forte, plus la quantité d'énergie restituée sera faible. Dès lors, même si l'accumulateur stocke une très grande quantité de charges, celles réellement disponibles seront plus faibles. La valeur de l'état de charge sera donc faussée, et ce d'autant plus que la résistance interne de l'accumulateur sera élevée.

Il a donc résulté une problématique consistant à trouver un autre indicateur plus représentatif de l'état réel de l'accumulateur.

On connaît du document FR2947637 un procédé de caractérisation de l'état d'énergie d'un accumulateur.

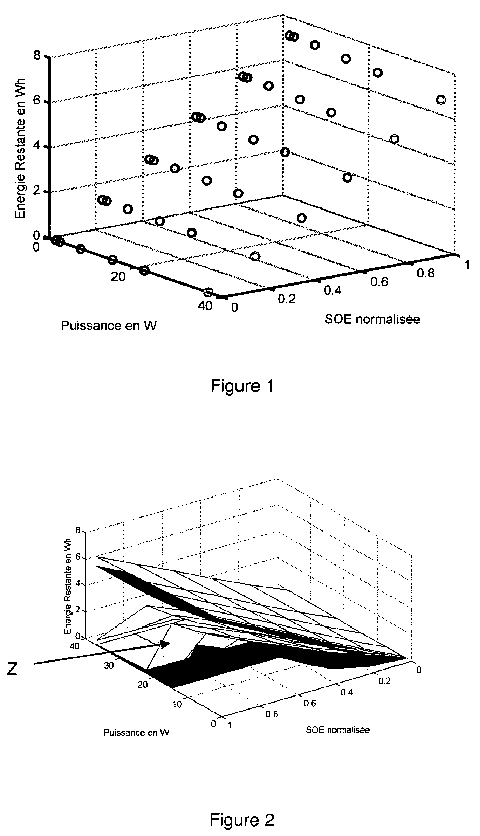

L'objectif de ce procédé est de déterminer quelques points caractéristiques du comportement de l'accumulateur qui définissent un ensemble de valeurs SOE (état d'énergie en Wh), P (puissance utile extraite en W), En (énergie restante en Wh), qui peuvent être représentés par cartographie dans un espace à trois dimensions comme illustré à la figure 1.

L'état d'énergie est relatif à l'énergie disponible à une puissance de référence. Cette puissance de référence peut être celle pour laquelle l'énergie disponible est maximale. L'état d'énergie (SOE "State Of Energy") varie alors de 0 à 1, ou de 0 à 100%. Par exemple, pour un accumulateur dont l'énergie de référence, à la puissance de référence, est de 10Wh, et en prenant un point expérimental SOE=50%, P=20W, En=3Wh, cela signifie que si l'accumulateur est utilisé en réalité à la puissance de 20W, il peut délivrer l'énergie restante de 3Wh (et non pas de 5Wh).

Les valeurs de SOE de la figure 1 permettant un tel raisonnement peuvent être déterminées à partir d'un accumulateur étalon, ou d'un ensemble d'accumulateurs formant batterie, et sont donc normalisées en laboratoire dans un environnement maîtrisé de puissance et d'énergie restante au niveau de l'accumulateur.

Il résulte de cette demande de brevet une problématique d'exploitation de ces données notamment dans le contexte d'une application embarquée en temps réel où les ressources de calcul sont limitées.

**Objet de l'invention**

Un but de la présente invention est de proposer une solution remédiant aux inconvénients listés ci-dessus, et permettant de calibrer/d'initialiser rapidement un accumulateur.

Un procédé de détermination selon l'invention est défini par la revendication 1.

Différents modes d'exécution du procédé de détermination sont définis par les revendications 2 à 9.

Un dispositif de détermination selon l'invention est défini par la revendication 10.

Un support d'enregistrement de données selon l'invention est défini par la revendication 11.

Un programme informatique selon l'invention est défini par la revendication 12.

Un procédé de traitement selon l'invention est défini par la revendication 13.

Différents modes d'exécution du procédé de traitement sont définis par les revendications 14 à 18.

## Description sommaire des dessins

D'autres avantages et caractéristiques ressortiront plus clairement de la description qui va suivre de modes particuliers de réalisation de l'invention donnés à titre d'exemples non limitatifs et représentés sur les dessins annexés, dans lesquels :

- la figure 1 représente la répartition de points de fonctionnement d'un accumulateur en fonction de l'énergie restante, de la puissance et de l'état d'énergie,
- la figure 2 représente une amélioration de la figure 1 dans le sens où la température de fonctionnement de l'accumulateur est aussi prise en compte par caractérisation expérimentale,
- la figure 3 illustre schématiquement le procédé de traitement d'un premier ensemble de données, par exemple du type de celles représentées à la figure 2 par caractérisation expérimentale,
- la figure 4 représente le raffinement par interpolation issu des données de la figure 2 après l'application du procédé de la figure 3,
- la figure 5 illustre un mode de réalisation particulier de la phase de constitution du troisième ensemble de quadruplets,
- la figure 6 illustre un graphique représentant la modélisation des points de fonctionnement à puissance et température fixées de l'énergie restante en fonction de l'état d'énergie,
- la figure 7 représente les étapes d'un procédé d'estimation de l'état d'énergie d'un accumulateur,
- la figure 8 représente différentes étapes possibles pour le calcul d'une valeur de pente,
- la figure 9 illustre une courbe représentative de l'état d'énergie en fonction du temps ,et une courbe représentative de l'évolution de la tension d'un accumulateur en fonction du temps dans une phase de validation du procédé de détermination de l'état d'énergie.

## Description de modes préférentiels de l'invention

Dans le cadre d'une application embarquée, la gestion des ressources pour déterminer un état d'énergie est un paramètre à ne pas négliger. Pour cela, il a été proposé de partir d'un premier ensemble de valeurs relatives à des points de fonctionnement d'un accumulateur électrochimique. Chaque point incluant une puissance P, un état d'énergie SOE et une énergie restante En, ou une puissance P, un état d'énergie SOE et une pente $\dfrac{dEn}{dSOE}$, regroupés en tenant compte d'une variable supplémentaire qu'est la température T. La température a été intégrée car elle influe sur le comportement de la résistance interne de l'accumulateur électrochimique.

Autrement dit, le premier ensemble peut être représentatif de quadruplets, se présentant par exemple sous la forme d'une table En=f(SOE, P, T) ou d'une table $\dfrac{dEn}{dSOE}$ =f(SOE, P, T).

Ces données peuvent être représentées sous la forme de cartographies comme illustrées à la figure 2. A la figure 2, on se situe dans un espace à trois dimensions donné par l'énergie restante en Wh, la puissance en W et l'état d'énergie SOE. Chaque nappe de cet espace délimite, en fonction de son maillage, une surface virtuelle associée à une température (5 températures dans l'exemple). Chaque maille de chaque nappe correspond à un point de fonctionnement déterminé par mesure expérimentale fonction du quadruplet (SOE, Energie restante, puissance, température). Le nombre de points de fonctionnement est assez faible, car même si les expériences sont automatisées, elles sont de longue durée. Il résulte donc un besoin de compléter ces cartographies initiales. Avant de détailler les étapes d'un mode d'exécution de l'invention, il convient au préalable d'apporter quelques définitions.

Un état d'énergie, dénommé « State Of Energy » SOE, est défini comme le rapport entre l'énergie $E_{d/PN}$ restante disponible à l'instant t dans l'hypothèse d'une décharge d'énergie dans les conditions nominales de l'accumulateur et l'énergie totale nominale $E_{Nom}$, donc défini par la formule SOE = $E_{d/PN}$ / $E_{Nom}$. Cette valeur de SOE est comprise entre 0 et 1, la valeur égale à 1 correspondant à un état d'énergie de l'accumulateur totalement chargé et la valeur égale à 0 comme un état totalement déchargé. Cette valeur peut aussi être exprimée en pourcentage.

La puissance P se trouve dans une plage de puissance d'utilisation recommandée par le fabricant de l'accumulateur, soit directement fournie par ce fabricant, soit déduite par exemple d'une plage de courant fournie par ce fabriquant, par multiplication par une tension nominale fournie. Cette puissance est fonction de l'état d'utilisation de l'accumulateur, à savoir la charge ou la décharge. En cas de décharge, on dira que la puissance P est prélevée à l'accumulateur, et en cas de charge, on dira que la puissance P est fournie à l'accumulateur. La puissance P disponible à l'instant t peut dépendre de l'état d'énergie et de la température.

Les états chargés et déchargés sont déterminés selon la technologie de l'accumulateur. Ils peuvent être obtenus à partir des recommandations du constructeur de l'accumulateur, et généralement à partir de tensions de seuil.

L'énergie restante En correspond à l'énergie utile de l'accumulateur, elle est exprimée en Wh, et prend en compte l'énergie interne réellement stockée dans l'accumulateur, et l'énergie perdue par effet joule dans la résistance interne de l'accumulateur. Ainsi, on a :

$$En=Ei-Ep$$

Avec

$Ep = \int r.I^2.dt$ : représentant l'énergie perdue par effet Joule dans la résistance interne de l'accumulateur, et
$Ei = Q.U$ : l'énergie interne stockée dans l'accumulateur.

La notion de pente est associée à l'énergie restante en fonction de l'état d'énergie. Elle correspond avantageusement à une valeur, pour une puissance et une température fixées, de la pente évaluée localement à un point formé par un couple énergie restante/état d'énergie d'une courbe passant par tous les points issus des couples énergie restante/état d'énergie, et associés à une même puissance et à une même température. Ainsi, la pente peut être associée à $\frac{dEn}{dSOE}$ ou à son inverse $\frac{dSOE}{dEn}$. De manière générale, dans la présente description la pente $\frac{dEn}{dSOE}$ ou $\frac{dSOE}{dEn}$ peut être remplacée par la pente de l'énergie restante En dans l'accumulateur en fonction de l'état d'énergie SOE de l'accumulateur.

Le premier ensemble de quadruplets peut être généré comme décrit dans la demande de brevet français publiée sous le numéro FR2947637 en prenant en compte en plus la température (Figure 2). Ainsi, la génération de ce premier ensemble ne sera pas re-décrit en détail ici. Bien que la demande de brevet français ne décrive pas l'obtention d'une table donnant $\frac{dEn}{dSOE}=f(SOE,\ P,\ T)$, il est clair que l'homme du métier saura traiter les informations de la demande de brevet français pour obtenir cette table. Typiquement à chaque point de la table initiale, on peut calculer une pente (En(i+1)-En(i))/(SOE(i+1)-SOE(i)), où i représente le rang dans la table initiale.

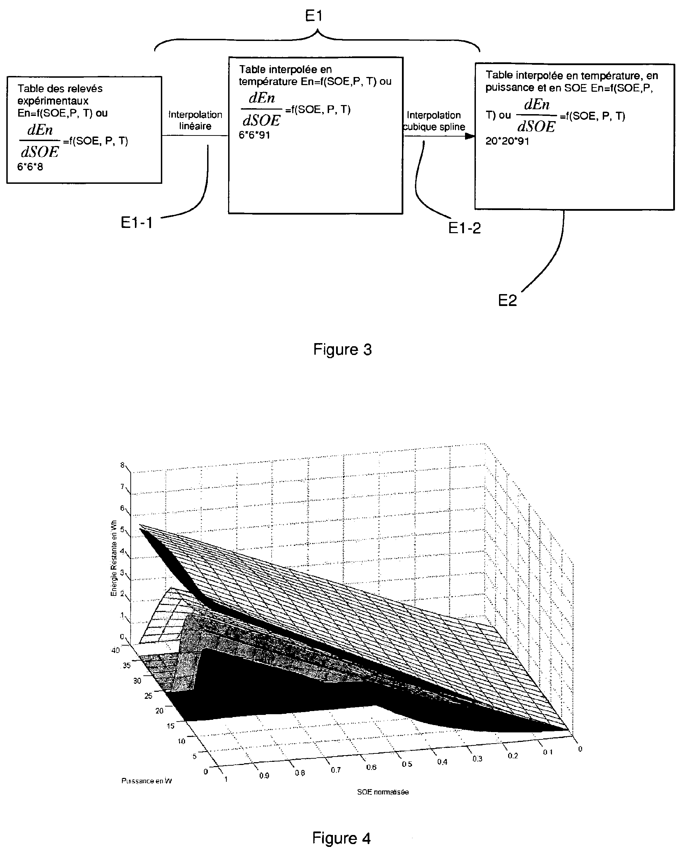

La figure 3 illustre une mise en oeuvre du procédé de traitement d'un premier ensemble de quadruplets de valeurs relatifs à des points de fonctionnement d'un accumulateur électrochimique incluant puissance P, température T, état d'énergie SOE et énergie restante En, par exemple de type En=f(SOE, P, T), ou puissance P, température T, état d'énergie SOE et pente, par exemple de type $\frac{dEn}{dSOE}=f(SOE,\ P,\ T)$ ou son inverse.

Ce procédé de traitement comprend une phase E1 de génération d'un deuxième ensemble de quadruplets par interpolation à partir du premier ensemble de quadruplets, la phase de génération incluant les étapes suivantes :

- réaliser E1-1 une interpolation, notamment une interpolation linéaire, en température T,
- réaliser E1-2 une interpolation, notamment une interpolation cubique spline, en puissance P et en état d'énergie SOE.

L'avantage de l'interpolation linéaire en température est qu'elle est simple à mettre en oeuvre en termes de simplicité de calculs. Pour l'interpolation cubique spline en puissance et en état d'énergie, elle permet d'obtenir des résultats plus réguliers et monotones.

Le procédé comporte en outre phase E2 de constitution d'un troisième ensemble de quadruplets, en particulier, à partir des premier et deuxième ensembles de quadruplets.

Avantageusement, le troisième ensemble de quadruplets comporte des valeurs relatives à des points de fonctionnement d'un accumulateur électrochimique incluant puissance (P), température (T), état d'énergie (SOE) et pente de l'énergie restante En dans l'accumulateur en fonction de l'état d'énergie SOE de l'accumulateur $(\dfrac{dEn}{dSOE}$ ou $\dfrac{dSOE}{dEn})$ à partir d'au moins le deuxième ensemble de quadruplets.

En fait, cette phase E2 de constitution du troisième ensemble de quadruplets peut plus généralement être réalisée d'au moins à partir du deuxième ensemble de quadruplets. Autrement dit, le troisième ensemble de quadruplets peut être en fait constitué uniquement par le deuxième ensemble de quadruplets. Selon cette réalisation, les phases de génération E1 et de constitution E2 ne constituent qu'une unique phase commune.

Selon une mise en oeuvre, la phase de constitution du troisième ensemble de quadruplets est définie par la réunion des premier et deuxième ensembles de quadruplets.

En effet, la notion « d'interpolation » consiste à déterminer, à partir d'une série statistique succincte, ici le premier ensemble de quadruplets, de nouvelles valeurs correspondant à un caractère intermédiaire pour lequel aucune mesure expérimentale n'a été effectuée. Autrement dit, les premier et deuxième ensembles de quadruplets sont avantageusement disjoints. Ainsi, la réunion des premier et deuxième ensembles permet d'obtenir un troisième ensemble contenant le plus de valeurs possibles.

Ainsi, les points de fonctionnement connus de l'accumulateur, à partir du premier ensemble de quadruplets, généralement issu de données expérimentales mesurées sur un accumulateur étalon, sont complétés. Ceci peut être réalisé en amont de l'application embarquée sur des machines puissantes, de sorte que l'application embarquée puisse exploiter ces résultats sans réaliser trop de calculs complexes.

L'exemple particulier de la figure 3 illustre que un premier temps, l'interpolation en température, de préférence par interpolation linéaire, peut être réalisée à partir du premier ensemble de quadruplets, formé dans l'exemple par En=f(SOE, P, T). Et dans un deuxième temps l'interpolation en puissance et en état d'énergie, par exemple cubique spline, est réalisée à partir d'un ensemble intermédiaire obtenu lors de l'interpolation en température. Avantageusement, le deuxième ensemble correspond donc à la réunion de l'ensemble intermédiaire, et de celui obtenu par interpolation en puissance et état d'énergie de cet ensemble intermédiaire.

L'ensemble intermédiaire peut aussi correspondre à la réunion du premier ensemble avec les données obtenues lors de l'interpolation en température. Dès lors, le troisième ensemble correspond à la réunion de l'ensemble intermédiaire, et de celui obtenu par interpolation en puissance et état d'énergie de cet ensemble intermédiaire.

Dans l'exemple particulier de la figure 3, à partir des relevés expérimentaux, on a une table d'origine de type En=f(SOE, P, T) donnant les valeurs d'énergie restante pour les combinaisons de six valeurs de SOE, de six valeurs de puissance P, et de huit valeurs de température T différentes.

L'interpolation, de préférence linéaire, en température est effectuée afin d'obtenir une série de données par degré Celsius, soit 91 séries de six puissances par six états d'énergie consécutivement à l'étape E1-1.

Chacune de ces séries fait ensuite l'objet d'une interpolation, de préférence cubique spline, de vingt puissances et vingt états d'énergie (étape E1-2).

La figure 4 illustre une représentation de l'exemple d'interpolation en puissance et en état d'énergie SOE. Pour des soucis de clarté de lecture de la figure 4, l'interpolation en température n'est pas représentée, et seules 5 nappes associées aux températures expérimentales sur les 91, après interpolation, sont représentées.

Ainsi, partant de données expérimentales de six points de SOE, six points de puissance P, huit points de température T, soit 288 points d'énergie, on génère un ensemble de vingt points de SOE, vingt points de puissance P, quatre-vingt-onze points de température T, soit 36400 points d'énergie.

Avec un codage des valeurs en flottant double précision, soit 8 octets par valeurs, le troisième ensemble peut occuper 36400x8 = 291200 octets.

L'interpolation sur 91 températures est pratique, car directement en degré Celsius sur une plage de fonctionnement généralement constatée des accumulateurs. Bien entendu, en fonction de la destination de l'accumulateur, l'homme du métier pourra adapter l'interpolation en température

En comparant la figure 2 avec la figure 4, on s'aperçoit qu'à la figure 4, dans une nappe, les irrégularités sont lissées, permettant ainsi de réaliser dans le futur une estimation d'état de charge plus précise.

Au total, la taille mémoire nécessaire pour loger la cartographie de cet exemple est de l'ordre de 300koctets, ce qui ne pose pas de problème d'intégration électronique, notamment dans les applications embarquées.

En prenant Np le nombre de graduations de puissances interpolées, Nsoe le nombre de graduations interpolées en état d'énergie, et Ntemp le nombre de graduations interpolées en températures, le nombre de quadruplets présents en mémoire sera de Ntemp*Np*Nsoe.

La Table I ci-dessous permet d'évaluer les ressources en taille mémoire (en kbits ou en koctets) pour stocker le troisième ensemble en fonction des valeurs de Ntemp, Nsoe et Np et du nombre de bits du codage.

Table I

| Np | Nsoe | Ntemp | Codage énergie (bits) | taille mémoire (kb) | taille mémoire (ko) |
|---|---|---|---|---|---|
| 10 | 10 | 91 | 16 | 146 | 18 |
| 10 | 10 | 91 | 32 | 291 | 36 |
| 10 | 10 | 91 | 64 | 582 | 73 |
| 20 | 20 | 91 | 16 | 582 | 73 |
| 20 | 20 | 91 | 32 | 1165 | 146 |
| 20 | 20 | 91 | 64 | 2330 | 291 |
| 40 | 40 | 91 | 16 | 2330 | 291 |
| 40 | 40 | 91 | 32 | 4659 | 582 |
| 40 | 40 | 91 | 64 | 9318 | 1165 |
| 100 | 100 | 91 | 16 | 14560 | 1820 |
| 100 | 100 | 91 | 32 | 29120 | 3640 |
| 100 | 100 | 91 | 64 | 58240 | 7280 |
| 100 | 100 | 25 | 16 | 4000 | 500 |
| 100 | 100 | 25 | 32 | 8000 | 1000 |
| 100 | 100 | 25 | 64 | 16000 | 2000 |

Même avec des interpolations et des codages de données à priori luxueux : 100x100x91 en 64 bits, la taille mémoire reste raisonnable, c'est-à-dire inférieure à 8Mo, largement intégrable sur une carte électronique.

La finesse de l'interpolation doit être optimisée en fonction de la précision de l'estimation d'état d'énergie souhaitée. Plus les fonctions de l'état d'énergie par rapport à la puissance d'utilisation et de la température sont irrégulières (voir zone Z sur la figure 2), plus un nombre important de points de modélisation/fonctionnement est avantageux.

On peut également augmenter le nombre de points de fonctionnement uniquement aux endroits où se situent les irrégularités, en réalisant dans ces endroits un nombre plus important d'interpolations. Cela peut permettre de diminuer la taille de la mémoire contenant la cartographie au détriment de la simplicité de recherche dans la mémoire lors de l'exécution de l'application.

Les cartographies, c'est-à-dire les points de fonctionnement supplémentaires issus des interpolations, peuvent être générées sur ordinateur à l'aide de logiciels de calculs scientifiques. Typiquement, il peut être utilisé des suites logicielles telles que matlab, mathcad, octave, scilab.

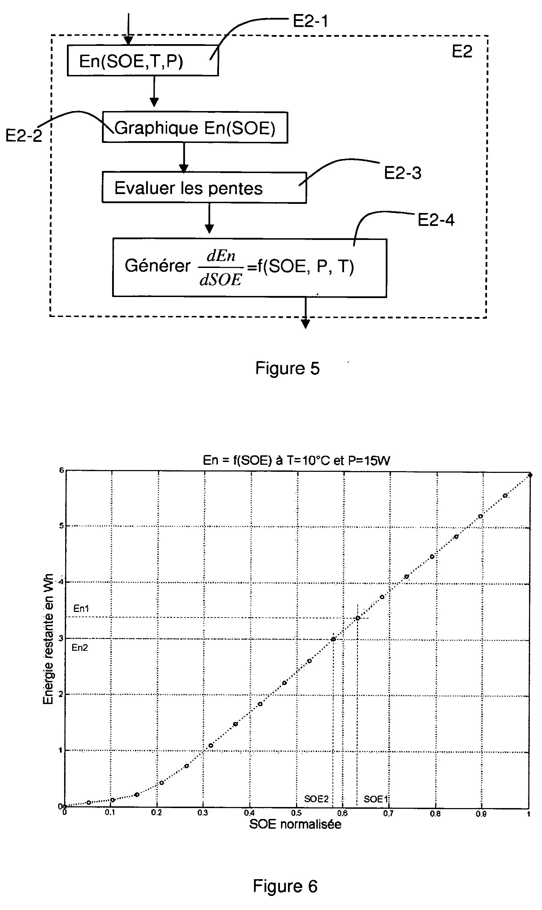

Selon un mode de réalisation particulier illustré à la figure 5, le premier ensemble de quadruplets et le deuxième ensemble de quadruplets sont relatifs à des points de fonctionnement d'un accumulateur électrochimique incluant puissance P, température T, état d'énergie SOE et énergie restante En, soit par exemple de type En=f(SOE, P, T). Et la phase de constitution du troisième ensemble de quadruplets comporte, à partir des premier et deuxième ensembles de quadruplets une étape de détermination du troisième ensemble de quadruplets de points de fonctionnement de l'accumulateur électrochimique incluant puissance P, température T, état d'énergie SOE et pente $\dfrac{dEn}{dSOE}$, c'est-à-dire par exemple de type $\dfrac{dEn}{dSOE}$=f(SOE, P, T). Ceci peut être réalisé après les interpolations en température et en puissance et état d'énergie, et avantageusement sur un ensemble de quadruplets, représentatif d'au moins la réunion du premier ensemble et du second ensemble (étape E2-1). Dans ce cas, la pente $\dfrac{dEn}{dSOE}$ peut être obtenue pour chaque combinaison de température T et de puissance P, avantageusement du troisième ensemble de quadruplets, de la manière suivante :

-    déterminer un ensemble de couples énergie restante/état d'énergie formant chacun un point de coordonnées formées par l'énergie restante et l'état d'énergie,

- évaluer E2-3 pour chaque couple de l'ensemble de couples une valeur de pente associée en fonction du point du couple traité et d'un autre point associé à un autre couple.

Autrement dit, c'est comme si on réalisait E2-2 un graphique de l'énergie restante en fonction de l'état d'énergie dans lequel chaque couple énergie restante/état d'énergie forme un point du graphique, avant d'évaluer E2-3 localement en chaque point du graphique la pente représentative d'une courbe passant par tous les points du graphique. L'étape E2-2 de la figure 5 et le graphique de la figure 6 sont uniquement présentes pour illustrer l'explication du procédé, l'étape E2-2 n'étant pas réalisée par le procédé.

L'évaluation locale de la pente pourra être réalisée par l'homme du métier en tenant compte classiquement du point précédent ou suivant de la courbe. La pente sera préférentiellement une valeur positive, et si elle est négative il s'agit d'un effet de bord de l'interpolation. En effet, une pente négative n'a pas de sens physique et cela signifierait que l'état d'énergie de l'accumulateur augmente alors qu'on le décharge. En fait, l'énergie restante et l'état d'énergie évoluent dans le même sens. Il arrive cependant qu'après l'interpolation en puissance et état d'énergie certaines pentes soient négatives, dans ce cas ces pentes sont écrêtées à une valeur positive légèrement supérieures à 0 afin de refléter une décharge (respectivement une charge) même faible lorsqu'une énergie est extraite (respectivement fournie).

Selon une variante, le premier ensemble est relatif à des quadruplets de valeurs relatifs à des points de fonctionnement de l'accumulateur électrochimique incluant puissance P, température T, état d'énergie SOE et pente $\frac{dEn}{dSOE}$ et le procédé comprend une étape préalable de détermination du premier ensemble à partir d'un quatrième ensemble de quadruplets de valeurs relatifs à des points de fonctionnement d'un accumulateur électrochimique incluant puissance P, température T, état d'énergie SOE et énergie restante En. La pente pourra alors être déterminée de la même manière qu'évoquée ci-dessus.

La figure 6 illustre pour une température fixée à 10°C et une puissance de 15W le graphique représentatif de l'énergie restante en Wh en fonction de l'état d'énergie SOE. La courbe fictive est représentée en pointillé et passe par tous les points du graphique.

Après avoir évalué localement, et en chaque point (énergie restante/état d'énergie), les pentes, il est facile d'obtenir une table regroupant puissance, température, état d'énergie et pente, et avantageusement donnant $\frac{dEn}{dSOE} = f(SOE, P, T)$ dans une étape E2-4, cette table étant alors représentative du troisième ensemble.

Le troisième ensemble tel que constitué dans le procédé ci-dessus dans toutes ses variantes peut être utilisé de manière générale dans un procédé de détermination de l'état d'énergie d'un accumulateur électrochimique. Ce procédé sera avantageusement mis en oeuvre en temps réel dans une application embarquée.

On comprend alors que le procédé de détermination de l'état d'énergie utilise avantageusement le troisième ensemble de quadruplets. Cependant, alternativement et de manière plus générale, le procédé comporte une étape dans laquelle il est utilisé un ensemble prédéterminé de quadruplets de valeurs relatifs à des points de fonctionnement d'un accumulateur électrochimique incluant puissance P, température T, état d'énergie SOE et énergie restante En, ou à des points de fonctionnement d'un accumulateur électrochimique incluant puissance P, température T, état d'énergie SOE et pente de l'énergie restante *En* dans l'accumulateur en fonction de l'état d'énergie *SOE* de l'accumulateur, notamment une pente $\frac{dEn}{dSOE}$ ou $\frac{dSOE}{dEn}$. Cet ensemble prédéterminé peut alors être le troisième ensemble de quadruplets ou être obtenu d'autres manières. Dès lors, dans la suite de la description le troisième ensemble de quadruplets peut avantageusement être remplacé par l'ensemble prédéterminé de quadruplets.

Le découpage en troisième ensemble tel que décrit, qui situe la modélisation et les calculs complexes en dehors de l'application temps réel, associé à un calcul itératif relativement simple et à quelques mesures à effectuer lors de l'exécution de l'application temps réel, ce que nous allons développer ci-dessous, donne accès à un indicateur d'état d'énergie qui peut être aisément intégré dans une électronique de gestion d'un système batterie (BMS - Battery Management System).

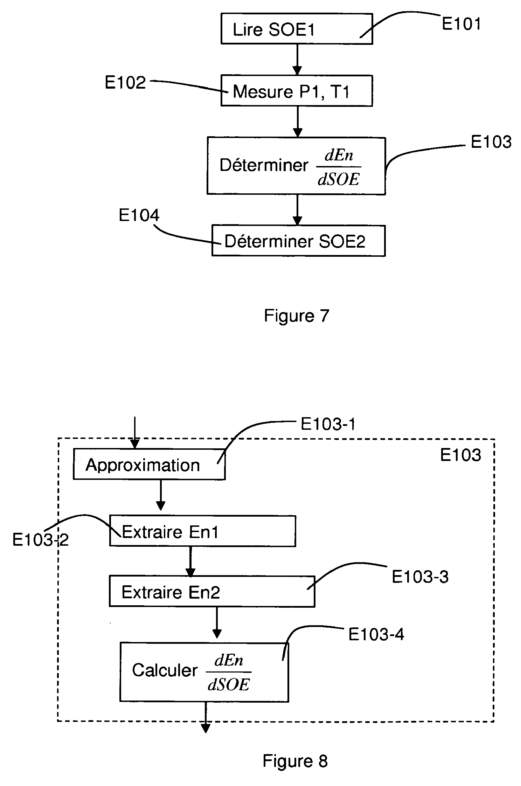

La figure 7 illustre une mise en oeuvre particulière du procédé de détermination de l'état d'énergie d'un accumulateur. Ce procédé, avantageusement itératif, comporte une étape E101 dans laquelle un premier état d'énergie SOE1 est lu dans une mémoire. Dans le cas où le procédé est itératif, la valeur SOE1 correspond à l'état d'énergie de l'accumulateur déterminé au pas précédent. Autrement dit, le cas échéant, à la fin de chaque itération, le procédé comporte avantageusement une étape de remplacement dans la mémoire de la valeur du premier état d'énergie SOE1 par la valeur d'un second état d'énergie SOE2, représentatif de l'état d'énergie que l'on cherchait à déterminer au cours de l'itération (aussi appelé état d'énergie courant), et qui sera utilisée en tant que premier état d'énergie dans l'itération suivante.

Dans le tout premier état d'initialisation, l'accumulateur peut être chargé à son maximum, et lors de l'arrêt de la charge, la valeur de la mémoire est représentative de 100%. Ou inversement, l'accumulateur peut être totalement déchargé, et la valeur mise en mémoire au moment de l'initialisation peut être représentative de 0%.

Ensuite, dans une étape E102 la température T1 et la puissance P1 représentatives du fonctionnement courant de l'accumulateur sont mesurées. Par « courant » on entend l'état de fonctionnement au cours de l'itération. Par température et puissance représentatives de l'accumulateur, on entend la puissance à laquelle de l'énergie est prélevée ou fournie à l'accumulateur, et la température de fonctionnement de l'accumulateur. A ce niveau la puissance est signée, c'est-à-dire qu'elle peut être positive ou négative. Une puissance positive sera représentative d'une phase de charge de l'accumulateur et une puissance négative sera représentative d'une phase de décharge de l'accumulateur. L'ensemble de quadruplets peut donc comporter des valeurs positives et des valeurs négatives de puissance. La température représentative de l'accumulateur doit être la plus proche de sa température interne, dès lors il est possible de placer un capteur de température dans l'accumulateur si la technologie du capteur peut résister à l'électrolyte. Bien entendu, le capteur de température sera avantageusement placé au même endroit que le capteur de température d'un accumulateur étalon ayant servi à former le premier ensemble. Bien qu'il soit possible d'avoir une table comportant des valeurs positives et négatives de puissance, par soucis de simplification l'entrée de la table est la valeur absolue de la puissance.

Dans une étape E103, la pente $\dfrac{dEn}{dSOE}$ de l'énergie restante *En* dans l'accumulateur en fonction de l'état d'énergie *SOE* de l'accumulateur à un point représentatif du premier état d'énergie SOE1, en fonction des température T1 et puissance P1 mesurées, est déterminée à partir du troisième ensemble de quadruplets. Cette pente $\dfrac{dEn}{dSOE}$ peut être déterminée par simple lecture si, par exemple, le troisième ensemble de quadruplets est du type $\dfrac{dEn}{dSOE} = \mathrm{f(SOE,\ P,\ T)}$, ou être obtenue par calcul si, par exemple, le troisième ensemble de quadruplets est du type En=f(SOE, P, T).

Enfin, un second état d'énergie SOE2, fonction de la pente déterminée $\dfrac{dEn}{dSOE}$, du premier état d'énergie SOE1, et d'une quantité d'énergie, est déterminé au cours de l'étape E104.

Ce second état d'énergie SOE2 correspond à l'état d'énergie courant de l'accumulateur que l'on cherchait à déterminer, et prend en compte ses variables de fonctionnement de puissance P1 et de température T1 mesurées.

Afin de limiter les calculs dans le cadre d'une application embarquée, il est avantageux de réaliser des approximations lors des différentes étapes du procédé de détermination de l'état d'énergie SOE.

Ainsi, la pente $\dfrac{dEn}{dSOE}$ est obtenue par approximation d'au moins une des valeurs suivantes de température mesurée T1, de puissance mesurée P1, du premier état d'énergie SOE1, à une valeur associée contenue dans le troisième ensemble de quadruplets. Avantageusement, toutes ces valeurs sont approximées, notamment si elles ne font pas parties de celles contenues dans le troisième ensemble.

En effet, en fonction de la résolution des capteurs de mesure, les valeurs mesurées de température T1 et de puissance P1, ou encore l'état d'énergie SOE1 lu pourront correspondre à des valeurs ne faisant pas parties du troisième ensemble de quadruplets. Pour limiter les ressources de l'application embarquée, il est avantageux que la détermination de l'état de charge prenne en compte des valeurs discrétisée, c'est-à-dire contenues dans le troisième ensemble. Pour cela, l'approximation peut correspondre à choisir une valeur associée du troisième ensemble la plus proche, ou à choisir une valeur associée du troisième ensemble immédiatement inférieure. Bien entendu, si on tombe directement sur des valeurs comprise dans le troisième ensemble, l'approximation ne sera pas nécessaire. Le choix d'une valeur la plus proche permet un résultat plus précis que le choix de la valeur immédiatement inférieure.

De manière avantageuse, le second état d'énergie SOE2 est obtenu par application de la formule $SOE2 \cong SOE1 + P.dt.\dfrac{dSOE}{dEn}$, où P.dt représente la quantité d'énergie. En fait, la quantité d'énergie est associée à une valeur positive de puissance fournie à l'accumulateur pendant une période déterminée au cours d'une phase de charge, ou à une valeur négative de puissance débitée par/prélevée à l'accumulateur pendant une période déterminée au cours d'une phase de décharge.

Ainsi, avant de déterminer l'état d'énergie SOE2, le procédé peut vérifier si l'accumulateur concerné est en phase de charge ou de décharge. Ceci peut être réalisé par tout moyen idoine connu de l'homme du métier, par exemple par mesure du courant.

Comme évoqué ci-dessus, la quantité d'énergie correspond à l'énergie prélevée ou fournie. En valeur, elle correspond à Qenergie = (En2-En1), où En1 correspond à l'énergie restante associée à SOE1, et En2 correspond à l'énergie restante associée à SOE2 (voir figure 6). Cette énergie peut être calculée de sorte que Qenergie=U.I.dt=P.dt. La dérivée temporelle dt correspond à la durée temporelle de la période déterminée. Précédemment, il a été expliqué que le procédé pouvait être itératif, ainsi, avantageusement, la période déterminée est représentative, ou égale, à la période d'itération du procédé. Dans le cas particulier où la pente doit être calculée, l'étape E103 de la figure 7 est détaillée à la figure 8. Tout d'abord, une approximation est réalisée E103-1 en choisissant pour la température mesurée T1, la puissance P1 mesurée et le premier état d'énergie SOE1, respectivement une température approximée T1 app, une puissance approximée P1 app et un premier état d'énergie SOE1app approximé. L'approximation de la valeur correspondante peut être réalisée en prenant, pour la température approximée et la puissance approximée, la valeur correspondante égale à la valeur mesurée, ou immédiatement inférieure à la valeur mesurée, ou la plus proche de la valeur mesurée, et présente dans le troisième ensemble de quadruplets, par exemple du type En=f(SOE, P, T). Pour SOE1app on prendra de préférence la valeur égale à la valeur de SOE1 ou immédiatement inférieure à SOE1 et comprise dans le troisième ensemble. Ensuite, une première énergie restante En 1, fonction des température T1 app, puissance P1 app et premier état d'énergie SOE1app approximés, est extraite E103-2 du troisième ensemble de quadruplets, par simple lecture puisqu'il s'agit d'une combinaison de valeurs connues et stockées dans le troisième ensemble de quadruplets. Par ailleurs, une seconde énergie restante En2, fonction des température T1 app et puissance P1 app approximées, et d'un second état d'énergie approximé SOE2app contenu dans le troisième ensemble et indexé dans un rang directement supérieur à celui associé au premier état d'énergie approximé SOE1app, est extraite E103-3 du troisième ensemble de quadruplets, toujours par simple lecture pour les mêmes raisons que celles évoquées ci-dessus. Par index supérieur, on entend la valeur SOE2app immédiatement supérieure à SOE1app pour la combinaison donnée T1 app et de P1 app. Bien qu'à la figure 8 l'étape E103-2 soit réalisée avant l'étape E103-3, cette séquence n'a pas d'importance du moment qu'au moment du calcul de la pente E103-4 on dispose des valeurs associées à En1, En2, SOE1app et SOE2app.

Enfin, la pente $\frac{dEn}{dSOE}$ est calculée E103-4 selon la formule $\frac{dEn}{dSOE}$=(En1-En2)/(SOE1app-SOE2app). Cette valeur de pente peut ensuite être celle utilisée dans l'étape E104 de la figure 7.

Il résulte de ce qui a été dit précédemment que l'utilisation d'un troisième ensemble de type $\frac{dEn}{dSOE}$=f(SOE, P, T) est avantageux dans le cadre d'une application embarquée, car on dispose directement de la pente. Ceci limite d'autant plus les ressources d'un calculateur embarqué mettant en oeuvre le procédé de détermination de l'état d'énergie, et permet d'obtenir plus rapidement une valeur de l'état d'énergie courante de l'accumulateur.

Il n'est pas impossible qu'entre deux itérations successives, la puissance ou la température change. Dans ce cas particulier, lors d'une itération, la détermination de l'état d'énergie courant prend en compte le changement de la température et/ou de la puissance par rapport à l'itération précédente.

En fait, par lecture de la mémoire pour déterminer la valeur SOE1 et en déterminant la pente à partir du troisième ensemble de quadruplets en fonction de la température mesurée et de la puissance mesurée, on tient automatiquement compte du changement de température ou de puissance. Du calcul itératif précédent, on ne retient que l'état d'énergie (soit SOE1 lors du nouveau pas). A partir des nouvelles mesures, on détermine la nouvelle puissance et la nouvelle température qui permettent d'accéder à la table pour déterminer l'énergie restante ou la pente, puis de calculer le nouvel état d'énergie SOE2. Par principe les variations de puissances et de températures sont donc prises en compte.

Il est possible que la formule $SOE2 \cong SOE1 + P.dt.\frac{dSOE}{dEn}$ soit corrigée en température. Elle sera donc remplacée par $SOE2 \cong SOE1 + effCh.P.dt.\frac{dSOE}{dEn}$ où effCh représente un coefficient de correction fonction de la charge ou de la décharge. L'utilisation du coefficient de correction permet d'éviter l'utilisation d'une table associée à la charge et d'une table associée à la décharge, il sera donc préféré car moins gourmand en termes de stockage.

La puissance peut être mesurée à partir de valeurs de tension de l'accumulateur et de courant traversant l'accumulateur.

Un support d'enregistrement de données lisible par un calculateur, sur lequel est enregistré un programme informatique pourra comprendre des moyens de codes de programme informatique de mise en oeuvre des étapes et/ou phase des procédés de traitement et/ou de détermination évoqués ci-dessus.

De manière analogue, un programme informatique pourra comprendre un moyen de codes de programme informatique adapté à la réalisation des étapes et/ou phases du procédé de détermination et/ou de traitement lorsque le programme est exécuté par un calculateur.L'invention est aussi relative à un dispositif de détermination d'un état d'énergie d'un accumulateur comprenant des moyens matériels et/ou logiciels de mise en oeuvre des étapes du procédé de détermination et/ou de traitement (ou plus particulièrement de mise en oeuvre du procédé de détermination et/ou de traitement). Typiquement, le dispositif peut comporter une mémoire dans laquelle le troisième ensemble est intégré, par exemple sous la forme d'une base de données dont les clés primaires sont la puissance, la température et l'état d'énergie donnant soit une unique valeur d'énergie restante, soit une unique valeur de pente. Ce dispositif peut comporter le support d'enregistrement et/ou le programme informatique décrits ci-avant.

On comprend alors de ce qui a été dit ci-dessus que le programme informatique du support d'enregistrement peut comprendre des moyens de codes de programme informatique exécutable par les moyens logiciels du dispositif tel que décrit pour mettre en oeuvre le procédé de détermination et/ou de traitement.

Par ailleurs, on comprend aussi que le programme informatique peut comprendre un moyen de codes de programme informatique exécutable par les moyens logiciels du dispositif tel que décrit pour la mise en oeuvre le procédé de détermination et/ou de traitement, notamment lorsque le programme est exécuté par un calculateur.

Ainsi, en temps réel, le dispositif permet de déterminer rapidement le point exact de fonctionnement de l'accumulateur pour extraire une valeur d'état d'énergie précise et cohérente.

Le procédé de détermination de l'état d'énergie tel que décrit ci-dessus a été testé sur un profil d'utilisation pour vérifier son efficacité. Les conditions de tests ont été les suivantes :

- l'application à un accumulateur d'un profil de puissance, présentant des phases de charge et de décharge,
- mesures de la tension aux bornes de l'accumulateur et de la température de l'accumulateur.

D'autre part, le profil de puissance et la température de fonctionnement de l'accumulateur ont été injectés dans une simulation de l'algorithme de calcul d'estimation de l'état d'énergie présenté précédemment.

Les résultats d'état d'énergie simulé et de la tension réellement mesurée peuvent alors être comparés.

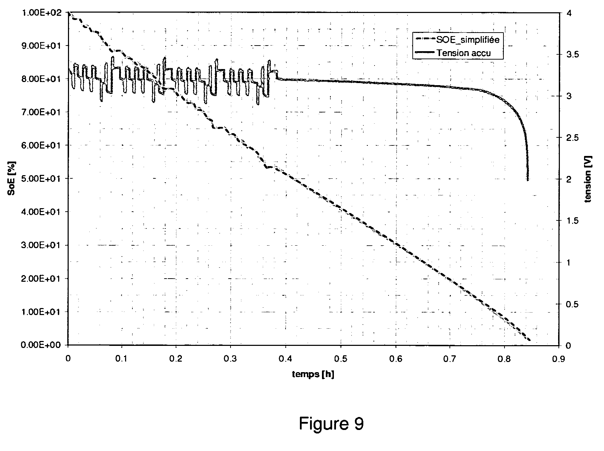

La figure 9 permet d'exploiter les résultats. Cette figure 9 montre l'état d'énergie SOE en fonction du temps, et la variation de la tension aux bornes de l'accumulateur en fonction du temps. Cette figure 9 montre qu'en fin de décharge, lorsque la tension atteint 2V environ, l'état d'énergie (SOE) est effectivement proche de 0 (1.48%). Cette marge d'erreur est très faible, et est satisfaisante dans le cadre de l'application embarquée.

La description mentionne un accumulateur électrochimique. La définition de l'accumulateur doit être prise au sens large, et vise tout aussi bien un accumulateur élémentaire ou une pluralité d'accumulateurs élémentaires agencés sous forme d'une batterie. L'accumulateur utilisé pour réaliser le test provient du fabricant A123system et porte la référence ANR26650M1.

**Revendications**

1. Procédé de détermination de l'état d'énergie d'un accumulateur électrochimique comportant les étapes suivantes :

   - utiliser un ensemble prédéterminé de quadruplets de valeurs relatifs à des points de fonctionnement de l'accumulateur électrochimique incluant puissance (P), température (T), état d'énergie SOE et énergie restante En, ou à des points de fonctionnement de l'accumulateur électrochimique incluant puissance (P), température (T), état d'énergie SOE et pente de l'énergie restante *En* dans l'accumulateur en fonction de l'état d'énergie *SOE* de l'accumulateur, notamment $\dfrac{dEn}{dSOE}$ ou $\dfrac{dSOE}{dEn}$,

   - lire (E101) dans une mémoire un premier état d'énergie SOE1,
   - mesurer (E102) une température (T1), et une puissance (P1), représentatives du fonctionnement courant de l'accumulateur,
   - déterminer (E103), à partir de l'ensemble prédéterminé de quadruplets, une pente de l'énergie restante *En* dans l'accumulateur en fonction de l'état d'énergie *SOE* de l'accumulateur, notamment une pente $\dfrac{dEn}{dSOE}$ ou $\dfrac{dSOE}{dEn}$, à un point représentatif du premier état d'énergie SOE1, en fonction des température et puissance mesurées (T1, P1),

- déterminer (E104) un second état d'énergie SOE2 fonction de la pente déterminée, notamment $\dfrac{dEn}{dSOE}$ ou $\dfrac{dSOE}{dEn}$, du premier état d'énergie SOE1, et d'une quantité d'énergie (P.dt).

2. Procédé selon la revendication précédente dans lequel la pente, notamment $\dfrac{dEn}{dSOE}$ ou $\dfrac{dSOE}{dEn}$, est obtenue par approximation d'au moins une des valeurs suivantes de température mesurée (T1), de puissance mesurée (P1), du premier état d'énergie (SOE1), à une valeur associée contenue dans l'ensemble prédéterminé de quadruplets.

3. Procédé selon la revendication 2 dans lequel l'approximation correspond à choisir une valeur associée de l'ensemble prédéterminé la plus proche, ou à choisir une valeur associée de l'ensemble prédéterminé immédiatement inférieure.

4. Procédé selon une des revendications 1 à 3 dans lequel le second état d'énergie SOE2 est obtenu par application de la formule $SOE2 \cong SOE1 + P.dt.\dfrac{dSOE}{dEn}$, où P.dt représente la quantité d'énergie, et est associée à une valeur positive de puissance fournie à l'accumulateur pendant une période déterminée au cours d'une phase de charge, ou à une valeur négative de puissance débitée par l'accumulateur pendant une période déterminée au cours d'une phase de décharge.

5. Procédé selon l'une des revendications 1 à 4, réalisé de manière itérative, dans lequel et comportant à la fin de chaque itération une étape de remplacement dans la mémoire de la valeur du premier état d'énergie SOE1 par la valeur du second état d'énergie SOE2 qui sera utilisée en tant que premier état d'énergie dans l'itération suivante.

6. Procédé selon les revendications 4 et 5 dans lequel la période déterminée (dt) est représentative d'une période d'itération du procédé.

7. Procédé selon l'une des revendications 1 à 6 dans lequel la pente, notamment $\dfrac{dEn}{dSOE}$ ou $\dfrac{dSOE}{dEn}$, est obtenue par simple lecture de l'ensemble prédéterminé de quadruplets.

8. Procédé selon l'une des revendications 1 à 6 dans lequel la pente, notamment $\dfrac{dEn}{dSOE}$ ou $\dfrac{dSOE}{dEn}$, est obtenue par calcul à partir de l'ensemble prédéterminé.

9. Procédé selon la revendication 8 dans lequel la pente, notamment $\dfrac{dEn}{dSOE}$ ou $\dfrac{dSOE}{dEn}$, est calculée de la manière suivante :

  - réaliser une approximation en choisissant pour la température mesurée (T1), la puissance mesurée (P1) et le premier état d'énergie (SOE1), respectivement une température approximée (T1 app), une puissance approximée (P1app) et un premier état d'énergie SOE1app approximé, lesdites valeurs approximées de température et de puissance étant des valeurs égales, immédiatement inférieures, ou plus proches des valeurs correspondantes mesurées et présente dans l'ensemble prédéterminé, la valeur approximée d'état d'énergie SOE1app étant la valeur égale, ou immédiatement inférieure, au premier état d'énergie SOE1 et présente dans l'ensemble prédéterminé,
  - extraire de l'ensemble prédéterminé une première énergie restante En1 fonction des température (T1app), puissance (P1app) et premier état d'énergie SOE1app approximés,
  - extraire de l'ensemble prédéterminé une seconde énergie restante En2 fonction des température (T1 app) et puissance approximées (P1 app), et d'un second état d'énergie approximé SOE2app contenu dans l'ensemble prédéterminé et indexé dans un rang directement supérieur à celui associé au premier état d'énergie approximé SOE1 app,

  - calculer la pente, notamment $\dfrac{dEn}{dSOE}$ ou $\dfrac{dSOE}{dEn}$, selon la formule

$$\frac{dEn}{dSOE} = (En1\text{-}En2)/(SOE1app\text{-}SOE2app).$$

10. Dispositif de détermination d'un état d'énergie d'un accumulateur comprenant des moyens matériels et logiciels de mise en oeuvre du procédé selon l'une des revendications 1 à 9.

11. Support d'enregistrement de données lisible par un calculateur, sur lequel est enregistré un programme informatique comprenant des moyens de codes de programme informatique exécutable par les moyens logiciels du dispositif selon la revendication 10 pour mettre en oeuvre le procédé selon l'une des revendications 1 à 9.

12. Programme informatique comprenant un moyen de codes de programme informatique exécutable par les moyens logiciels du dispositif selon la revendication 10 pour la mise en oeuvre du procédé selon l'une des revendications 1 à 9, notamment lorsque le programme est exécuté par un calculateur.

13. Procédé de traitement d'un premier ensemble de quadruplets de valeurs relatifs à des points de fonctionnement d'un accumulateur électrochimique incluant puissance (P), température (T), état d'énergie (SOE) et énergie restante (En), ou à des points de fonctionnement de l'accumulateur électrochimique incluant puissance (P), température (T), état d'énergie (SOE) et pente de l'énergie restante En dans l'accumulateur en fonction de l'état d'énergie SOE de l'accumulateur, notamment $\frac{dEn}{dSOE}$ ou $\frac{dSOE}{dEn}$, ledit procédé comprenant :

- une phase de génération (E1) d'un deuxième ensemble de quadruplets par interpolation à partir du premier ensemble de quadruplets, la phase de génération incluant les étapes suivantes :

a. réaliser (E1-1) une interpolation, notamment une interpolation linéaire, en température (T),
b. réaliser (E1-2) une interpolation, notamment une interpolation cubique spline, en puissance (P) et en état d'énergie (SOE),

- une phase (E2) de constitution d'un troisième ensemble de quadruplets de valeurs relatifs à des points de fonctionnement d'un accumulateur électrochimique incluant puissance (P), température (T), état d'énergie (SOE) et pente de l'énergie restante En dans l'accumulateur en fonction de l'état d'énergie SOE de l'accumulateur $\left(\frac{dEn}{dSOE}, \frac{dSOE}{dEn}\right)$ à partir d'au moins le deuxième ensemble de quadruplets.

14. Procédé selon la revendication 13 dans lequel la phase de constitution (E2) du troisième ensemble de quadruplets est définie par la réunion des premier et deuxième ensembles de quadruplets.

15. Procédé selon l'une quelconque des revendications 13 ou 14, dans lequel le premier ensemble de quadruplets est issu de données expérimentales mesurées sur un accumulateur étalon.

16. Procédé selon l'une quelconque des revendications 13 à 15 dans lequel dans un premier temps, l'interpolation en température (E1-1) est réalisée à partir du premier ensemble de quadruplets, et en ce que dans un deuxième temps l'interpolation en puissance et en état d'énergie (E1-2) est réalisée à partir d'un ensemble intermédiaire obtenu suite à l'interpolation en température (E1-1).

17. Procédé selon l'une quelconque des revendications 13 à 16, dans lequel:

- le premier ensemble est relatif à des quadruplets de valeurs relatifs à des points de fonctionnement de l'accumulateur électrochimique incluant puissance (P), température (T), état d'énergie (SOE) et pente $\left(\frac{dEn}{dSOE}, \frac{dSOE}{dEn}\right)$, et en ce que le procédé comprend une étape préalable de détermination du premier ensemble à partir d'un quatrième ensemble de quadruplets de valeurs relatifs à des points de fonctionnement d'un accumulateur électrochimique incluant puissance (P), température (T), état d'énergie (SOE) et énergie restante (En), ou en ce que :

- les premier et deuxième ensembles sont relatifs à des quadruplets de valeurs relatifs à des points fonctionnement d'un accumulateur électrochimique incluant puissance (P), température (T), état d'énergie (SOE) et énergie restante (En), et en ce que la phase de constitution du troisième ensemble comprend une étape de détermination du troisième ensemble de quadruplets de points fonctionnement de l'accumulateur électrochimique incluant puissance (P), température (T), état d'énergie (SOE) et pente $(\frac{dEn}{dSOE}, \frac{dSOE}{dEn})$ a partir des premier et deuxième ensembles de quadruplets.

18. Procédé selon la revendication précédente dans lequel la pente $(\frac{dEn}{dSOE})$ est obtenue pour chaque combinaison de température (T) et de puissance (P) de la manière suivante :

- déterminer un ensemble de couples énergie restante/état d'énergie formant chacun un point de coordonnées formées par l'énergie restante et l'état d'énergie,
- évaluer (E2-3) pour chaque couple de l'ensemble de couples une valeur de pente associée en fonction du point du couple traité et d'un autre point associé à un autre couple.

**Patentansprüche**

1. Verfahren zur Bestimmung des Energiezustandes eines elektrochemischen Akkumulators, umfassend die folgenden Schritte:

- Verwendung einer vorbestimmten Einheit von Vierergruppen von Werten in Bezug auf Funktionspunkte des elektrochemischen Akkumulators, umfassend Leistung (P), Temperatur (T), Energiezustand SOE und Restenergie En oder auf Funktionspunkte des elektrochemischen Akkumulators, umfassend Leistung (P), Temperatur (T), Energiezustand SOE und Gefälle der Restenergie En im Akkumulator in Abhängigkeit vom Energiezustand SOE des Akkumulators, insbesondere $\frac{dEn}{dSOE}$ oder $\frac{dSOE}{dEn}$,
- Ablesen (E101) eines ersten Energiezustands SOE1 im Speicher,
- Messen (E102) einer Temperatur (T1) und einer Leistung (P1), die für die laufende Funktion des Akkumulators repräsentativ sind,
- Bestimmen (E103) aus der vorbestimmten Einheit von Vierergruppen eines Gefälles der Restenergie En in dem Akkumulator in Abhängigkeit von dem Energiezustand SOE des Akkumulators, insbesondere ein Gefälle $\frac{dEn}{dSOE}$ oder $\frac{dSOE}{dEn}$ an einem Punkt, der für den ersten Energiezustand SOE1 repräsentativ ist, in Abhängigkeit von der gemessenen Temperatur und Leistung (T1, P1),
- Bestimmen (E104) eines zweiten Energiezustandes SOE2 in Abhängigkeit von dem bestimmten Gefälle, insbesondere $\frac{dEn}{dSOE}$ oder $\frac{dSOE}{dEn}$, des ersten Energiezustandes SOE1 und einer Energiemenge (P.dt).

2. Verfahren nach dem vorhergehenden Anspruch, bei dem das Gefälle, insbesondere $\frac{dEn}{dSOE}$ oder $\frac{dSOE}{dEn}$, durch Annäherung mindestens eines der folgenden Werte der gemessenen Temperatur (T1), der gemessenen Leistung (P1), des ersten Energiezustandes (SOE1) an einen zugehörigen Wert, der in der vorbestimmten Einheit von Vierergruppen enthalten ist, erhalten wird.

3. Verfahren nach Anspruch 2, bei dem die Annäherung der Auswahl eines der nächsten vorbestimmten Einheit zugehörigen Werts oder der Auswahl eines der unmittelbar darunter liegenden vorbestimmten Einheit zugehörigen Werts entspricht.

4. Verfahren nach einem der Ansprüche 1 bis 3, bei dem der zweite Energiezustand SOE2 durch Anwendung der Formel $SOE2 \cong SOE1 + P.dt.\frac{dSOE}{dEn}$ erhalten wird, wobei P.dt die Energiemenge darstellt, und einem positiven Leistungswert zugeordnet ist, der an den Akkumulator während einer bestimmten Periode während einer Ladephase geliefert wird, oder einem negativen Leistungswert zugeordnet ist, der vom Akkumulator während einer bestimmten Periode während einer Entladephase abgegeben wird.

5. Verfahren nach einem der Ansprüche 1 bis 4, das auf iterative Weise durchgeführt wird, umfassend am Ende jeder Iteration einen Schritt des Ersatzes des Werts des ersten Energiezustandes SOE1 durch den Wert des zweiten Energiezustandes SOE2 im Speicher, welcher als erster Energiezustand in der folgenden Iteration verwendet wird.

6. Verfahren nach den Ansprüchen 4 und 5, bei dem die bestimmte Periode (dt) für eine Iterationsperiode des Verfahrens repräsentativ ist.

7. Verfahren nach einem der Ansprüche 1 bis 6, bei dem das Gefälle, insbesondere $\frac{dEn}{dSOE}$ oder $\frac{dSOE}{dEn}$, durch einfaches Ablesen der vorbestimmten Einheit von Vierergruppen erhalten wird.

8. Verfahren nach einem der Ansprüche 1 bis 6, bei dem das Gefälle, insbesondere $\frac{dEn}{dSOE}$ oder $\frac{dSOE}{dEn}$, durch Berechnung aus der vorbestimmten Einheit erhalten wird.

9. Verfahren nach Anspruch 8, bei dem das Gefälle, insbesondere $\frac{dEn}{dSOE}$ oder $\frac{dSOE}{dEn}$, folgendermaßen berechnet wird:

- Durchführen einer Annäherung durch Auswahl für die gemessene Temperatur (T1), die gemessene Leistung (P1) und den ersten Energiezustand (SOE1) jeweils einer angenäherten Temperatur (T1app), einer angenäherten Leistung (P1app) und eines angenäherten ersten Energiezustandes SOE1app, wobei die angenäherten Werte von Temperatur und Leistung gleiche, unmittelbar darunter liegende oder den gemessenen entsprechenden Werten nähere und in der vorbestimmten Einheit vorhandene Werte sind, wobei der angenäherte Wert eines Energiezustandes SOE1app der Wert gleich oder unmittelbar unter dem ersten Energiezustand SOE1 und in der vorbestimmten Einheit vorhanden ist,
- Extrahieren aus der vorbestimmten Einheit einer ersten Restenergie En1 in Abhängigkeit von der angenäherten Temperatur (T1app), der angenäherten Leistung (P1app) und dem ersten angenäherten Energiezustand SOE1app,
- Extrahieren aus der vorbestimmten Einheit einer zweiten Restenergie En2 in Abhängigkeit von der angenäherten Temperatur (T1app), Leistung (P1app) und einem zweiten angenäherten Energiezustand SOE2app, der in der vorbestimmten Einheit enthalten und auf einem Rang direkt über jenem, der dem ersten angenäherten Energiezustand SOE1app zugeordnet ist, indexiert ist,

- Berechnen des Gefälles, insbesondere $\frac{dEn}{dSOE}$ oder $\frac{dSOE}{dEn}$ nach der Formel

$$\frac{dEn}{dSOE} = (En1 - En2)/(SOE1app - \ SOE2app).$$

10. Vorrichtung zur Bestimmung eines Energiezustandes eines Akkumulators, umfassend Hardware- und Softwaremittel für den Einsatz des Verfahrens nach einem der Ansprüche 1 bis 9.

11. Von einem Rechner lesbarer Datenaufzeichnungsträger, auf dem ein Computerprogramm aufgezeichnet ist, umfassend Codemittel eines Computerprogramms, das von den Softwaremitteln der Vorrichtung nach Anspruch 10 ausführbar ist, um das Verfahren nach einem der Ansprüche 1 bis 9 einzusetzen.

12. Computerprogramm, umfassend ein Codemittel eines Computerprogramms, das von den Softwaremitteln der Vorrichtung nach Anspruch 10 für den Einsatz des Verfahrens nach einem der Ansprüche 1 bis 9 ausführbar ist, insbesondere wenn das Programm durch einen Rechner ausgeführt wird.

13. Verfahren zur Verarbeitung einer ersten Einheit von Vierergruppen von Werten in Bezug auf Funktionspunkte eines elektrochemischen Akkumulators, umfassend Leistung (P), Temperatur (T), Energiezustand (SOE) und Restenergie (En) oder auf Funktionspunkte des elektrochemischen Akkumulators, umfassend Leistung (P), Temperatur (T), Energiezustand (SOE) und Gefälle der Restenergie En im Akkumulator in Abhängigkeit vom Energiezustand SOE des Akkumulators, insbesondere $\frac{dEn}{dSOE}$ oder $\frac{dSOE}{dEn}$, wobei das Verfahren umfasst:

- eine Phase der Erzeugung (E1) einer zweiten Einheit von Vierergruppen durch Interpolation aus der ersten Einheit von Vierergruppen, wobei die Erzeugungsphase die folgenden Schritte einschließt:

a. Durchführen (E1-1) einer Interpolation, insbesondere einer linearen Interpolation in Temperatur (T),
b. Durchführen (E1-2) einer Interpolation, insbesondere einer kubischen Spline-Interpolation, in Leistung (P) und Energiezustand (SOE),

- eine Phase (E2) der Bildung einer dritten Einheit von Vierergruppen von Werten in Bezug auf Funktionspunkte eines elektrochemischen Akkumulators, umfassend Leistung (P), Temperatur (T), Energiezustand (SOE) und Gefälle der Restenergie En im Akkumulator in Abhängigkeit vom Energiezustand SOE des Akkumulators $(\frac{dEn}{dSOE}, \frac{dSOE}{dEn})$ aus mindestens der zweiten Einheit von Vierergruppen.

14. Verfahren nach Anspruch 13, bei dem die Phase der Bildung (E2) der dritten Einheit von Vierergruppen durch die Vereinigung der ersten und zweiten Einheiten von Vierergruppen definiert ist.

15. Verfahren nach einem der Ansprüche 13 oder 14, bei dem die erste Einheit von Vierergruppen aus an einem Eichakkumulator gemessenen experimentellen Daten stammt.

16. Verfahren nach einem der Ansprüche 13 bis 15, bei dem erstens die Interpolation in Temperatur (E1-1) aus der ersten Einheit von Vierergruppen durchgeführt wird, und bei dem zweitens die Interpolation in Leistung und Energiezustand (El-2) aus einer Zwischeneinheit, die nach der Interpolation in Temperatur (E1-1) erhalten wird, durchgeführt wird.

17. Verfahren nach einem der Ansprüche 13 bis 16, bei dem:

- sich die erste Einheit auf Vierergruppen von Werten in Bezug auf Funktionspunkte des elektrochemischen Akkumulators, umfassend Leistung (P), Temperatur (T), Energiezustand (SOE) und Gefälle $(\frac{dEn}{dSOE}, \frac{dSOE}{dEn})$, bezieht, und das Verfahren einen vorherigen Schritt der Bestimmung der ersten Einheit aus einer vierten Einheit von Vierergruppen von Werten in Bezug auf Funktionspunkte eines elektrochemischen Akkumulators, umfassend Leistung (P), Temperatur (T), Energiezustand (SOE) und Restenergie (En), umfasst, oder bei dem:
- sich die erste und zweite Einheit auf Vierergruppen von Werten in Bezug auf Funktionspunkte eines elektrochemischen Akkumulators, umfassend Leistung (P), Temperatur (T), Energiezustand (SOE) und Restenergie (En), beziehen, und die Phase der Bildung der dritten Einheit einen Schritt der Bestimmung der dritten Einheit von Vierergruppen von Funktionspunkten eines elektrochemischen Akkumulators, umfassend Leistung (P), Temperatur (T), Energiezustand (SOE) und Gefälle $(\frac{dEn}{dSOE}, \frac{dSOE}{dEn})$ aus der ersten und zweiten Einheit von Vierergruppen umfasst.

18. Verfahren nach dem vorhergehenden Anspruch, bei dem das Gefälle $(\frac{dEn}{dSOE})$ für jede Kombination von Temperatur (T) und Leistung (P) folgendermaßen erhalten wird:

- Bestimmen einer Einheit von Paaren Restenergie/Energiezustand, die jeweils einen Punkt von Koordinaten bilden, die von der Restenergie und dem Energiezustand gebildet sind,
- Bewerten (E2-3) für jedes Paar der Einheit von Paaren eines zugehörigen Gefällewerts in Abhängigkeit vom Punkt des bearbeiteten Paars und von einem anderen Punkt, der einem anderen Paar zugeordnet ist.

## Claims

1. Method for determining the state of energy of an electrochemical accumulator, including the following steps:

- using a predetermined set of quadruplets of values relating to operating points of the electrochemical accumulator, including power (P), temperature (T), state of energy SOE and remaining energy En, or to operating points of the electrochemical accumulator, including power (P), temperature (T), state of energy SOE and slope of the remaining energy *En* in the accumulator as a function of the state of energy *SOE of* the accumulator,

notably $\dfrac{dEn}{dSOE}$ or $\dfrac{dSOE}{dEn}$ ,

- reading (E101) a first state of energy SOE1 from a memory,
- measuring (E102) a temperature (T1), and a power (P1), representing the current operation of the accumulator,
- determining (E103), on the basis of the predetermined set of quadruplets, a slope of the remaining energy *En*

in the accumulator as a function of the state of energy *SOE of* the accumulator, notably a slope $\dfrac{dEn}{dSOE}$ or

$\dfrac{dSOE}{dEn}$ , at a point representing the first state of energy SOE1, as a function of the measured temperature and measured power (T1, P1),

- determining (E104) a second state of energy SOE2 as a function of the determined slope, notably $\dfrac{dEn}{dSOE}$

or $\dfrac{dSOE}{dEn}$ , of the first state of energy SOE1, and an energy quantity (P.dt).

2. Method according to the preceding claim, wherein the slope, notably $\dfrac{dEn}{dSOE}$ or $\dfrac{dSOE}{dEn}$ , is obtained through approximation of at least one of the following values of measured temperature (T1), measured power (P1), the first state of energy (SOE1), at an associated value contained in the predetermined set of quadruplets.

3. Method according to Claim 2, wherein the approximation corresponds to choosing a closest associated value of the predetermined set, or to choosing an immediately lower associated value of the predetermined set.

4. Method according to one of Claims 1 to 3, wherein the second state of energy SOE2 is obtained by applying the

formula $SOE2 \cong SOE1 + P.dt.\dfrac{dSOE}{dEn}$ , where P.dt is the energy quantity, and is associated with a positive power value supplied to the accumulator during a predetermined period during a charging phase, or a negative power value output by the accumulator during a predetermined period during a discharging phase.

5. Method according to one of Claims 1 to 4, carried out iteratively, and including, at the end of each iteration, a step of replacing the value of the first state of energy SOE1 in the memory with the value of the second state of energy SOE2 which will be used as the first state of energy in the following iteration.

6. Method according to Claims 4 and 5, wherein the determined period (dt) represents a period of iteration of the method.

7. Method according to one of Claims 1 to 6, wherein the slope, notably $\dfrac{dEn}{dSOE}$ or $\dfrac{dSOE}{dEn}$ , is obtained through simple reading of the predetermined set of quadruplets.

8. Method according to one of Claims 1 to 6, wherein the slope, notably $\dfrac{dEn}{dSOE}$ or $\dfrac{dSOE}{dEn}$ , is obtained through calculation on the basis of the predetermined set.

9. Method according to Claim 8, wherein the slope, notably $\dfrac{dEn}{dSOE}$ or $\dfrac{dSOE}{dEn}$ , is calculated in the following manner:

- carrying out an approximation by choosing, for the measured temperature (T1), the measured power (P1) and the first state of energy (SOE1), an approximated temperature (T1 app), an approximated power (P1 app) and an approximated first state of energy SOE1app respectively, said approximated temperature and power values being values equal to, immediately below, or closest to the corresponding measured values and present in the predetermined set, the approximated value of the state of energy SOE1app being the value equal to, or immediately below, the first state of energy SOE1 and present in the predetermined set,

- extracting, from the predetermined set, a first remaining energy En1, a function of the approximated temperature (T1 app), approximated power (P1 app) and approximated first state of energy SOE1app,

- extracting, from the predetermined set, a second remaining energy En2 as a function of the approximated temperature (T1 app) and approximated power (P1 app), and a second approximated state of energy SOE2app contained in the predetermined set and indexed in a row directly above the row associated with the first approximated state of energy SOE1app,

- calculating the slope, notably $\dfrac{dEn}{dSOE}$ or $\dfrac{dSOE}{dEn}$, according to the formula

$$\frac{dEn}{dSOE} = (En1-En2)/(SOE1app-SOE2app).$$

10. Device for determining a state of energy of a accumulator, including hardware and software means for carrying out the method according to one of Claims 1 to 9.

11. Computer-readable data recording medium on which a computer program is recorded, including computer program code means executable by the software means of the device according to Claim 10 to carry out the method according to one of Claims 1 to 9.

12. Computer program, including a computer program code means executable by the software means of the device according to Claim 10 for carrying out the method according to one of Claims 1 to 9, notably when the program is executed by a computer.

13. Method for processing a first set of quadruplets of values relating to operating points of an electrochemical accumulator, including power (P), temperature (T), state of energy (SOE) and remaining energy (En), or to operating points of the electrochemical accumulator, including power (P), temperature (T), state of energy (SOE) and slope of the remaining energy En in the accumulator according to the state of energy SOE of the accumulator, notably

$\dfrac{dEn}{dSOE}$ or $\dfrac{dSOE}{dEn}$, said method including:

- a phase (E1) of generating a second set of quadruplets through interpolation on the basis of the first set of quadruplets, the generation phase including the following steps:

a. carrying out (E1-1) an interpolation, notably a linear interpolation, in temperature (T),
b. carrying out (E1-2) an interpolation, notably a cubic spline interpolation, in power (P) and in state of energy (SOE),

- a phase (E2) of forming a third set of quadruplets of values relating to operating points of an electrochemical accumulator, including power (P), temperature (T), state of energy (SOE) and slope of the remaining energy

En in the accumulator as a function of the state of energy SOE of the accumulator $\left(\dfrac{dEn}{dSOE}, \dfrac{dSOE}{dEn}\right)$ on the basis of at least the second set of quadruplets.

14. Method according to Claim 13, wherein the phase (E2) of forming the third set of quadruplets is defined by the union of the first and second sets of quadruplets.

15. Method according to one of Claims 13 and 14, wherein the first set of quadruplets originates from experimental data measured on a standard accumulator.

16. Method according to any one of Claims 13 to 15, wherein, firstly, the interpolation in temperature (E1-1) is carried out on the basis of the first set of quadruplets, and in that, secondly, the interpolation in power and in state of energy (E1-2) is carried out on the basis of an intermediate set obtained following the interpolation in temperature (E1-1).

17. Method according to any one of Claims 13 to 16, wherein:

- the first set relates to quadruplets of values relating to operating points of the electrochemical accumulator, including power (P), temperature (T), state of energy (SOE) and slope $\left( \dfrac{dEn}{dSOE}, \dfrac{dSOE}{dEn} \right)$, and in that the method includes a prior step of determining the first set on the basis of a fourth set of quadruplets of values relating to operating points of an electrochemical accumulator, including power (P), temperature (T), state of energy (SOE) and remaining energy (En), or in that:

- the first and second sets relate to quadruplets of values relating to operating points of an electrochemical accumulator, including power (P), temperature (T), state of energy (SOE) and remaining energy (En), and in that the phase of forming the third set includes a step of determining the third set of quadruplets of operating points of the electrochemical accumulator, including power (P), temperature (T), state of energy (SOE) and slope $\left( \dfrac{dEn}{dSOE}, \dfrac{dSOE}{dEn} \right)$ on the basis of the first and second sets of quadruplets.

18. Method according to the preceding claim, wherein the slope $\left( \dfrac{dEn}{dSOE} \right)$ is obtained for each combination of temperature (T) and power (P) in the following manner:

- determining a set of remaining energy/state of energy pairs, each forming a point of coordinates formed by the remaining energy and the state of energy,
- evaluating (E2-3), for each pair of the set of pairs, an associated slope value as a function of the point of the processed pair and a different point associated with a different pair.

Figure 1

Figure 2

E1

Table des relevés expérimentaux En=f(SOE,P, T) ou

$$\frac{dEn}{dSOE} = f(SOE, P, T)$$

6*6*8

Interpolation linéaire

Table interpolée en température En=f(SOE,P, T) ou

$$\frac{dEn}{dSOE} = f(SOE, P, T)$$

6*6*91

Interpolation cubique spline

Table interpolée en température, en puissance et en SOE En=f(SOE,P, T) ou

$$\frac{dEn}{dSOE} = f(SOE, P, T)$$

20*20*91

E1-1

E1-2

E2

Figure 3

Figure 4

Figure 5

En = f(SOE) à T=10°C et P=15W

Figure 6

Lire SOE1 — E101

E102 — Mesure P1, T1

Déterminer $\dfrac{dEn}{dSOE}$ — E103

E104 — Déterminer SOE2

Figure 7

E103-1 — Approximation

E103

E103-2 — Extraire En1

Extraire En2 — E103-3

Calculer $\dfrac{dEn}{dSOE}$ — E103-4

Figure 8

Figure 9

**RÉFÉRENCES CITÉES DANS LA DESCRIPTION**

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

- FR 2947637